**Europäisches Patentamt**

**European Patent Office**

**Office européen des brevets**

(19)

(11) Veröffentlichungsnummer: **0 077 539**
**B1**

(12) # EUROPÄISCHE PATENTSCHRIFT

(45) Veröffentlichungstag der Patentschrift:
**18.01.89**

(21) Anmeldenummer: **82109548.6**

(22) Anmeldetag: **15.10.82**

(51) Int. Cl.⁴: **H 01 L 39/24**, H 01 L 39/02

(54) **Verfahren zur Herstellung einer supraleitenden Verbindungsstelle.**

(30) Priorität: **21.10.81 DE 3141660**

(43) Veröffentlichungstag der Anmeldung:
**27.04.83 Patentblatt 83/17**

(45) Bekanntmachung des Hinweises auf die Patenterteilung:
**18.01.89 Patentblatt 89/3**

(84) Benannte Vertragsstaaten:
**CH FR GB IT LI NL**

(56) Entgegenhaltungen:
**WO-A-80/02084**
**US-A- 3 449 818**

(73) Patentinhaber: **Asea Brown Boveri Aktiengesellschaft,
Kallstadter Strasse 1, D-6800 Mannheim-Käfertal (DE)**

(72) Erfinder: **Wahl, Georg, Dr., Dipl.-Phys.,
Franz-List-Strasse 9, D-6904 Eppelheim (DE)**
Erfinder: **Dustmann, Cord-Heinrich, Dr., Dipl.-Phys.,
Diemstrasse 10, D-6940 Weinheim (DE)**

(74) Vertreter: **Kempe, Wolfgang, Dr. et al, c/o BROWN,
BOVERI & CIE AG ZPT Postfach 351,
D-6800 Mannheim 31 (DE)**

**Beschreibung**

Die Erfindung betrifft ein Verfahren zur Herstellung einer supraleitenden Verbindungsstelle zwischen wenigstens zwei Supraleitern. Es kann sich hierbei um eine Verbindungsstelle zwischen den Enden koaxialer Supraleiter, aber auch um eine Verbindungsstelle zwischen beliebig anders geformten Supraleitern sowie um eine Verbindungsstelle zwischen mittleren Bereichen von Supraleitern handeln.

Bei Supraleiteranordnungen müssen häufig Verbindungen zwischen zwei Supraleitern hergestellt werden, deren Übergangswiderstand nach Möglichkeit Null ist.

Beispielsweise sind Schaltungsanordnungen bekannt, bei denen supraleitende Spulen mit supraleitenden Schaltern verbunden sind. Solche Schaltungsanordnungen werden u.a. bei der Hochfrequenzspektroskopie für die Herstellung grosser, zeitlich sehr konstanter Magnetfelder verwendet. Dabei werden die Leiterenden einer supraleitenden Magnetspule über einen supraleitenden Schalter miteinander verbunden. Zum Auferregen der Spule wird der supraleitende Schalter z.B. durch Heizen normalleitend gemacht. Nach Erreichen des Sollstromes wird der supraleitende Schalter durch Abkühlen wieder supraleitend gemacht, wodurch die Leiterenden der supraleitenden Spule über den supraleitenden Schalter kurzgeschlossen werden.

Die zeitliche Konstanz des so eingestellten Magnetfeldes ist abhängig von dem Verhältnis der Spuleninduktivität L zum Widerstand R des kurzgeschlossenen Kreises. Der Widerstand R wird entscheidend durch den Widerstand der Kontaktierung zwischen den Leiterenden der supraleitenden Spule und dem supraleitenden Schalter bestimmt.

Für die Kontaktierung supraleitender Drähte und Filamente sind mehrere Verbindungsmöglichkeiten bekanntgeworden:

Das Verlöten von Drähten ist allgemein bekannt. Es lassen sich minimale Übergangswiderstände von ca. $10^{-8}$ Ohm erreichen, was für die oben genannte Anwendung in den meisten Fällen unzureichend ist.

Bei einem Kaltpressschweiss-Verfahren (D.N. Cornish, D.W. Deis, J.P. Zbasnik, Cold-pressurewelded Joints in Large Multifilamentary NbTi Superconductors. 7th Symposium on Engineering Problems of Fusion Research, Knoxville, USA Oct. 1977 p 1266) werden die zu verbindenden Drähte unter Zuhilfenahme eines angepassten Werkzeuges mit den Leiterenden stumpf zusammengeschoben, so dass das Material ineinanderfliesst und seitlich herausquillt. Die Verbindungsstelle muss anschliessend verputzt werden. Es ist keine supraleitende Verbindung erreichbar. Die mechanische Festigkeit beträgt ca. 90% der Festigkeit des Drahtes.

Beim Ultraschallschweissen werden die Leiterenden mit Hilfe von Ultraschall miteinander verschweisst. Eine supraleitende Verbindung ist auch hier nicht möglich.

Beim Explosionsschweissen (D.N. Cornish, J.P. Zbasnik, and H.E. Pattee, «Explosive Joints in Nb-Ti/Cu Composite Superconductors», in Proc. 6the Symp. Engrg. Problems of Fusion Res., San Diego, 1975 (IEEE, New York, 1976) p 106 werden die Leiterenden mit Hilfe von Sprengladungen explosionsverschweisst. Das Verfahren ist nur in geschützten Räumen an frei zugänglichen Leiterenden möglich. Ein supraleitende Verbindung ist auch hier nicht möglich, weil nie alle Filamente aufeinander treffen.

Beim Schweisspunkten von Niobtitan-Filamenten (G. Luderer, P. Dullenkopf, G. Laukien, «Superconducting joint between multifilamentary wires. Cryogenics 14, 518 (1974) werden die Filamente von NbTi-Supraleiterdrähten einzeln mit einer NbTi-Folie verschweisst. Es ist eine supraleitende Verbindung mit gegenüber dem Ausgangsdraht reduzierten Supraleitungsdaten möglich. Das Verfahren ist jedoch sehr aufwendig und auf Drähte mit begrenzter Filamentzahl beschränkt, da jedes Filament einzeln verschweisst werden muss.

Schliesslich ist eine Diffusionsverbindung bei $Nb_3Sn$-Drähten bekannt. Bei $Nb_3Sn$-Drähten werden die supraleitenden Materialschichten erst bei einer abschliessenden Reaktionsglühung gebildet. Bei einer geeigneten Anordnung der Nb-Filamente vor dem Glühprozess ist es erreichbar, die supraleitenden Materialschichten der Drahtenden durch Diffusion miteinander zu verbinden. Es lassen sich gute Übergangswerte erreichen. Das Verfahren ist aufwendig und auf durch Diffusionsglühen hergestellte Supraleiter begrenzt.

In der US-Patentschrift US-A-3 449 818 wird eine supraleitende Verbindungsstelle dadurch geschaffen, dass die Enden von zwei supraleitenden Drähten zunächst mit einer supraleitenden Wismut-Blei-Zinn-Verbindung verzinnt werden und innerhalb einer supraleitenden Hülse in Kontakt gebracht werden. Um einen guten Kontakt zwischen Hülse und supraleitenden Drähten herzustellen, wird daraufhin die gesamte Anordnung verpresst.

Aufgabe der Erfindung ist es, ein Verfahren zur Herstellung einer supraleitenden Verbindungsstelle zwischen wenigstens zwei Supraleitern zu schaffen, die mit möglichst geringem Aufwand unter Vermeidung der Nachteile genannter Verfahren herstellbar ist, einen möglichst geringen Übergangswiderstand aufweist und eine ausreichende mechanische Festigkeit der Verbindungsstelle gewährleistet.

Diese Aufgabe wird erfindungsgemäss dadurch gelöst, dass die die Verbindungsstelle bildenden supraleitenden Schichten der Supraleiter von Belägen befreit werden, die supraleitenden Schichten zur Überlappung gebracht werden und supraleitende Zwischenschichten mittels chemischer Abscheidung aus der Gasphase zur Kontaktierung auf die supraleitenden Schichten aufgebracht werden.

Eine derart hergestellte Verbindungsstelle stellt einen supraleitenden Kontakt dar. Sie lässt sich mit relativ geringem Aufwand durch Freilegen und Reinigen der supraleitenden Schichten (z.B. Abätzen der umhüllenden Kupferschicht), Überlappen der zu verbindenden Supraleiterbereiche und Aufbringen der supraleitenden Zwischenschichten durch chemische Abscheidung aus der Gasphase herstellen. Geeignete Gasphasenabscheide-Verfahren, kurz CVD (Chemical Vapor Deposition)-Verfahren genannt, sind bsw. durch die DE-AS 2 856 885 bekanntgeworden. Ein CVD-Reaktorgefäss kann über den Überlappungsbereich der Verbindungsstelle gestülpt werden, wobei die Zuleitungen der zu verbindenden Supraleiter durch Durchführungen in dem Reaktorgefäss hindurchragen können. Das CVD-Verfahren kann in einer mobilen CVD-Anlage durchgeführt werden, so dass auch eine Montagekontaktierung an Baustellen ect. möglich ist.

Besonders vorteilhaft ist es, das erfindungsgemässe Verfahren mittels eines im Zentrum der Verbindungsstelle angeordneten Heizelementes auszuführen.

Durch ein solches Heizelement lässt sich bei der Herstellung der Verbindungsstelle der Reaktionsablauf des CVD-Verfahrens steuern, denn es ist z.B. bekannt (E. Fitzer, D. Kehr, Processing Studies of the Chemical Vapor Deposition of Niobium and Tantalium, Proceeding of the IVth International CVD Conference, eds. G.F. Wakefield, J.M. Blocher, ECS 1973, p 144-146), dass bei Nb die Abscheidegeschwindigkeit mit sinkender Temperatur sinkt. Durch Erzeugung eines Temperaturgradienten mit abnehmender Temperatur vom Zentrum der Verbindungsstelle aus, kann z.B. das Schichtwachstum so gesteuert werden, dass die Zwischenschichten sich vom Inneren zum Äusseren der Verbindungsstelle aufbauen und eine Abkapselung noch unbeschichteter Bereiche durch bereits abgeschiedenes Nb vermieden wird.

Das Heizelement kann z.B. ein Heizdraht (Heizleiter) sein, der bsw. bei einer zylinderförmig ausgebildeten Verbindungsstelle koaxial verläuft. Eine Temperatursteuerung kann jedoch auch durch Induktion oder auf andere Weise vorgenommen werden.

In vorteilhafter Weise wird das Verfahren bei einer Verbindungsstelle zwischen solchen Supraleitern, die aus supraleitenden Filament- und/oder Faserleitern bestehen, so durchgeführt, dass zunächst die einzelnen Filament- oder Faserleiter der miteinander zu verbindenden Supraleiter miteinander zu einem gemeinsamen Strang verflochten, gespleisst oder vertwistet werden. Hierdurch erhält die Verbindungsstelle eine hohe Stromtragfähigkeit und hohe mechanische Festigkeit.

Ferner kann in vorteilhafter Weise der Überlappungsbereich der Verbindungsstelle durch Drahtgeflecht oder eine Drahtumwicklung umgeben sein. Die Umhüllung dient dem Zusammenhalt der Verbindungsstelle vor dem Durchführen des chemischen Abscheidungsprozesses und der Ausbildung einer ausreichenden mechanischen Festigkeit der Verbindungsstelle. Zwischen den Drähten der Umhüllung müssen Zwischenräume frei bleiben, um das Eindringen des Materials bei der Zwischenbeschichtung zu ermöglichen. Als Drahtmaterial eignet sich bsw. Wolfram, Nickel oder Tantal.

Im Bereich der Verbindungsstelle sind, wie oben erläutert wurde, etwaige Kupferschichten, z.B. Kupfermatrix, oder andere bei Normalleitung den Strom tragende Beschichtungen entfernt worden. Hier können sich daher lediglich supraleitende Materialien und weniger gut leitende Trägersubstanzen, z.B. Kohlefasern, die in die durch das CVD-Verfahren aufgebrachten Zwischenschichten aus supraleitendem Material eingebettet sind, befinden. Um im Bereich der Verbindungsstelle eine ausreichende Stromtragfähigkeit auch im Normalleitungszustand sicherzustellen, um ferner eine genügende cryogene Stabilisierung des Supraleiters und um eine gute Wärmeableitung zu gewährleisten, ist es daher vorteilhaft, dass der Bereich der Verbindungsstelle durch ein hochleitfähiges Material, insbesondere hochreines Kupfer, dessen Querschnitt den Anforderungen der Kühlung und der Stromtragfähigkeit genügt, überbrückt ist.

Diese Überbrückung erfolgt vorzugsweise, durch Ummantelung der Verbindungsstelle mit hochleitfähigem Material mit geringem Restwiderstand, d.h. einem hohen Widerstandsverhältnis (= Verhältnis des spezifischen Widerstandes bei Raumtemperatur zum spezifischen Widerstandswert bei der Temperatur des flüssigen Helium).

Eine supraleitende Verbindungsstelle kann zwischen allen Supraleitern hergestellt werden, die die CVD-Prozesstemperatur unbeschadet überstehen. Als supraleitende Zwischenschichten sind alle aus der Gasphase durch CVD abscheidbare supraleitenden Materialien geeignet.

An Hand der Zeichnung, in der ein Ausführungsbeispiel der Erfindung gezeigt wird, sollen die Erfindung sowie weitere vorteilhafte Ausgestaltungen und Weiterbildung näher erläutert werden.

Es zeigt:

Fig. 1 eine Verbindungsstelle zwischen zwei aus Faserleitern bestehenden Supraleiterenden in Seitenansicht mit im Schnitt dargestellter Ummantelung und

Fig. 2 den Schnitt einer Verbindungsstelle zwischen zwei aus Faserleitern bestehenden Supraleitern.

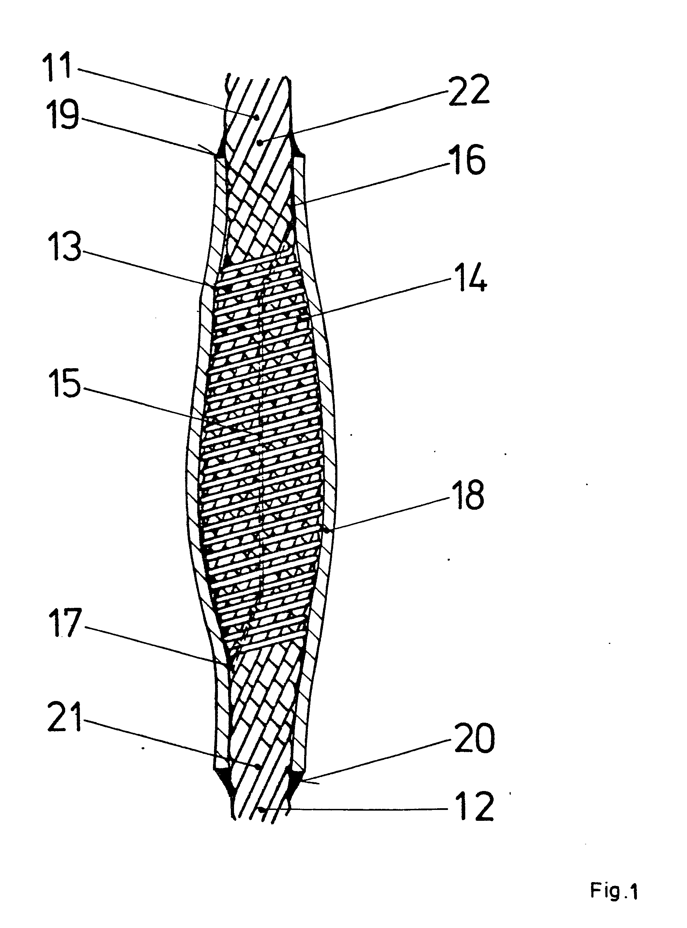

Bei der in Fig. 1 dargestellten Verbindungsstelle sind zwei Supraleiter 11, 12 miteinander verbunden. Die Supraleiter 11, 12 bestehen aus einer Vielzahl gegeneinander verdrehter und vermischter Faserleiter 21, 22, z.B. Kohlenstoffasern mit einer dünnen Schicht einer supraleitenden Niobverbindung der allgemeinen Formel $NbC_xN_y$, die in einer Kupfermatrix eingebettet sind. Im Bereich der Verbindungsstelle sind die Faserleiter 21, 22 aus der Kupfermatrix herausgelöst (z.B. durch Ätzen in verdünnter Schwefelsäure). Die freien Faserleiterenden der beiden Supraleiter 11, 12 sind miteinander getwistet, vermischt und zu einem überlappenden Strang 13 durch eine Drahtumwicklung 14 verbunden.

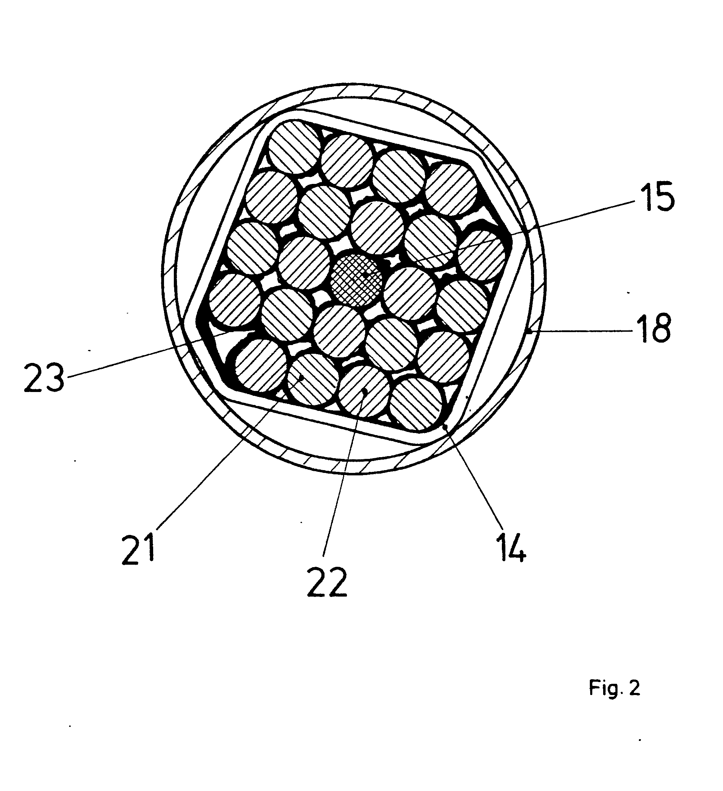

Innerhalb des überlappenden Stranges 13 ist ein Heizleiter 15 erkennbar, der in etwa axial angeordnet ist und in den beiden Endbereichen der Überlappung jeweils an die Oberfläche tritt. Der Heizleiter ist lediglich bei der Herstellung der Verbindung zwischen den Faserleitern, auf die im Anschluss an die Beschreibung zur Fig. 2 eingegangen wird, von Bedeutung. Die nach Aussen tretenden Heizleiterenden 16, 17 sind nach Herstellung der Verbindungsstelle gekappt und enden an der Oberfläche des überlappenden Stranges 13.

Der überlappende Strang 13 ist durch einen rohrförmigen Mantel 18 umgeben. Der Mantel 18 liegt an dem überlappenden Strang 13 eng an. Er besteht aus hochreinem Kupfer. Seine Rohrenden sind jeweils mit einem der beiden miteinander verbundenen Supraleiter 11, 12 verlötet (Lötnähte 19, 20). Die Wandstärke des Mantels 18 ist so ausgewählt, dass der Mantel 18 den Nennstrom des Supraleiters aufnehmen kann, wenn die Verbindungsstelle von der Supraleitung in die Normalleitung übergeht.

Die Fig. 2 zeigt den Querschnitt einer Verbindungsstelle gemäss Fig. 1, jedoch in einem anderen, vergrösserten Massstab. Die Verbindungsstelle besteht aus einem Bündel von Faserleitern 21, 22, welches durch die Drahtumwicklung 14 und einen rohrförmigen Mantel 18 umgeben ist. Die beiden unterschiedlichen Schraffuren der Faserleiter 21, 22 zeigen an, dass jeder Faserleiter 21, 22 einem der beiden miteinander verbundenen Supraleiter 11, 12 zuzuordnen ist. In der Verbindungsstelle, sind die Faserleiter 21, 22 der beiden Supraleiter 11, 12 miteinander vermischt. In der Mitte, zwischen den Faserleitern 21, 22 ist durch Kreuzschraffur ein Heizleiter 15 angedeutet. Zwischen den Faserleitern 21, 22 sind Abscheidungsschichten 23 (schwarz gezeichnet), einer supraleitenden Niobverbindung erkennbar.

Eine supraleitende Verbindungsstelle zwischen zwei Supraleitern 11, 12, wie sie in Fig. 1 bzw. Fig. 2 dargestellt ist, lässt sich in der Weise herstellen, dass zunächst aus den beiden zu verbindenden Supraleiterenden die Faserleiter 21, 22 aus der Kupfermatrix durch Ätzen herausgelöst werden. Die nunmehr freiliegenden Faserenden eines Supraleiters 11, die, wie erwähnt wurde, aus Kohlenstofffasern mit einer dünnen Umhüllung einer supraleitenden Niobverbindung bestehen können, werden mit den Faserleiterenden des anderen Supraleiters 12 gespleisst, dabei wird ein Heizleiter 15 mit eingeflochten, der in etwa axial in der Verbindungsstelle angeordnet wird. Um die gespleissten Faserenden zusammenzuhalten, wird eine Drahtumwicklung 14 um den Bereich der Verbindungsstelle gelegt, deren einzelne Windungen nicht eng aneinanderliegen.

Die Verbindungsstelle wird in einen CVD-Reaktor eingebracht, wobei sich lediglich der Bereich der Verbindungsstelle im Reaktorraum befindet und die Supraleiter 11, 12 durch Durchführungen im Reaktorgehäuse nach aussen geführt sind. Im CVD-Reaktor wird aus der Gasphase eine Niobverbindung der allgemeinen Formel $NbC_xN_y$ abgeschieden, die sich an den Faserleiteroberflächen anlagert und zu einem Zusammenwachsen der Faserleiter 21, 22 führt. Die Abscheidegeschwindigkeit ist temperaturabhängig und steigt mit wachsender Temperatur. Durch den zentral gelegenen Heizleiter 15, wird die Temperatur in der Verbindungsstelle während des Abscheidungsprozesses langsam hoch geregelt, so dass die Abscheidung zunächst vom Inneren der Verbindungsstelle einsetzt und langsam zonenweise nach aussen fortgesetzt wird. Hierdurch kann vermieden werden, dass sich im Inneren grössere Hohlräume bilden, was zu geringeren Ablagerungsschichtdicken 23 und einer schlechteren supraleitenden Verbindung zwischen den Faserleitern 21, 22 führt.

Im Anschluss an den CVD-Prozess werden die nunmehr überflüssigen Heizleiterenden 16, 17 gekappt. Über die Verbindungsstelle wird ein rohrförmiger Mantel 18 aus hochreinem Kupfer gelegt (z.B. durch Umwickeln mit Kupferblech), dessen beiden Enden jeweils mit einem der beiden Supraleiter 11, 12 verlötet werden. Hierdurch kann ein guter elektrischer Kontakt und Wärmeübergang gewährleistet werden. Die Schichtdicke des Mantels 18 wird so stark gewählt, dass neben der Stromtragfähigkeit im normalleitenden Zustand die cryogene Stabilisierung der Verbindungsstelle, d.h. die Vermeidung eines Temperaturanstieges über die kritische Temperatur $T_c$ hinaus, sichergestellt werden kann.

**Patentansprüche**

1. Verfahren zur Herstellung einer supraleitenden Verbindungsstelle zwischen wenigstens zwei Supraleitern (11, 12), bei dem die die Verbindungsstelle bildenden supraleitenden Schichten der Supraleiter von Belägen befreit werden, die supraleitenden Schichten zur Überlappung gebracht werden und supraleitende Zwischenschichten (23) mittels chemischer Abscheidung aus der Gasphase zur Kontaktierung auf die supraleitenden Schichten aufgebracht werden.

2. Verfahren zur Herstellung einer supraleitenden Verbindungsstelle zwischen Supraleitern (11, 12), die aus supraleitenden Filament- und/oder Faserleitern (21, 22) bestehen, nach Anspruch 1, dadurch gekennzeichnet, dass die einzelnen Filament- oder Faserleiter (21, 22) im Bereich der Verbindungsstelle miteinander verflochten oder vertwistet werden.

3. Verfahren nach Anspruch 1 oder 2, dadurch gekennzeichnet, dass zum Zweck eines vom Inneren der Verbindungsstelle zur Peripherie fortschreitenden zonenweisen Aufbaus der supraleitenden Zwischenschichten (23) diese mittels eines ins Innere der Verbindungsstelle zentral verbrachten Heizleiters (15) längs eines zur Peripherie abfallenden Temperaturgradienten aufgeheizt wird.

4. Verfahren nach Anspruch 3, dadurch gekennzeichnet, dass an der Oberfläche des überlappenden Strangs (13) austretende Heizleiterenden (16, 17) nach Herstellung der Verbindungsstelle gekappt werden.

5. Verfahren nach einem der Ansprüche 1 bis 4, dadurch gekennzeichnet, dass der Überlappungsbereich der supraleitenden Verbindungsstelle vor dem Durchführen des chemischen Abscheidungsprozesses aus der Gasphase zum Zwecke der Stabilisierung und zum Zwecke der Ausbildung ausreichender bleibender mechanischer Festigkeit der Verbindungsstelle mit einem Drahtgeflecht oder einer Drahtumwicklung (14) umgeben wird, wobei zwischen den einzelnen Drähten des Drahtgeflechts bzw. zwischen den Windungen der Drahtumwicklung (14) Zwischenräume frei bleiben.

6. Verfahren nach einem der Ansprüche 1 bis 5, dadurch gekennzeichnet, dass der Bereich der Verbindungsstelle mittels eines hochleitfähigen Materials, vorzugsweise mittels eines geschlossenen Mantels (18) aus Kupfer, dessen Querschnitt entsprechend den an Kühlung und Stromtragfähigkeit zu stellenden Anforderungen dimensioniert ist, elektrisch parallel überbrückt wird.

## Claims

1. Method of making a superconducting joint between at least two superconductors (11, 12), wherein the superconducting layers of the superconductors, which form the joint, are freed from coverings, the superconducting layers are made to overlap, and superconducting intermediate layers (23) are deposited on the superconducting layers for the purpose of bonding by means of chemical deposition from the vapour phase.

2. Method according to Claim 1 of making a superconducting joint between superconductors (11, 12), which consist of superconducting multifilamentary conductors and/or fibre conductors (21, 22), characterized in that the individual multifilamentary or fibre conductors (21, 22) are interwoven or twisted with one another in the region of the joint.

3. Method according to Claim 1 or 2, characterized in that the superconducting intermediate layers (23) are heated along a temperature gradient declining towards the periphery by means of a heating conductor (15) introduced centrally into the interior of the joint, so that they will be built up progressively in zones from the interior towards the periphery.

4. Method according to Claim 3, characterized in that heating conductor ends (16, 17) emerging at the surface of the overlapping strand (13) are capped once the joint has been made.

5. Method according to one of Claims 1 to 4, characterized in that for the purpose of stabilizing and for the purpose of the formation of sufficient remaining mechanical strength of the joint, before the execution of the process of chemical deposition from the vapour phase the overlap region of the superconducting joint is surrounded by a wire mesh or a wire serving (14), interstices remaining free between the individual wires of the wire mesh or between the turns of the wire serving (14).

6. Method according to one of Claims 1 to 5, characterized in that the region of the joint is shunted electrically in parallel by means of a highly conducting material, preferably by means of a closed sheath (18) of copper, whose cross-section is dimensioned in accordance with the requirements to be placed on cooling and current-carrying capacity.

## Revendications

1. Procédé de réalisation d'une connexion supraconductrice entre au moins deux supraconducteurs (11, 12), dans lequel les couches supraconductrices des supraconducteurs constituant la connexion sont débarassées de revêtement, les couches supraconductrices sont mises en condition de chevauchement et des couches intermédiaires supraconductrices (23) sont appliquées, par dépôt chimique à partir d'une phase gazeuse, sur les couches supraconductrices, pour réaliser le contact de jonction.

2. Procédé selon revendication 1 pour réaliser une connexion supraconductrice entre supraconducteurs (11, 12) constitués par des conducteurs sous forme de filaments et/ou fibres supraconducteurs (21, 22), caractérisé par le fait que les conducteurs individuels sous forme de filaments ou de fibres (21, 22) sont entrelacés ou commis en torsade dans la région de la connexion.

3. Procédé selon revendication 1 ou 2, caractérisé par le fait que, pour obtenir une formation par zones des couches intermédiaires supraconductrices (23), progressant de l'intérieur de la connexion vers la périphérie, des couches intermédiaires sont chauffées le long d'un gradient de température décroissant vers la périphérie, au moyen d'un conducteur chauffant (15) disposé centralement à l'intérieur de la connexion.

4. Procédé selon revendication 3, caractérisé par le fait qu'après réalisation de la connexion, les extrémités (16, 17) des conducteurs chauffants débordant à la surface de la veine d'entrelacs (13) sont coupées.

5. Procédé selon l'une des revendications 1 à 4, caractérisé par le fait que, pour la stabilisation et pour l'obtention d'une résistance mécanique permanente suffisante de la connexion, on entoure, par une tresse de fils ou par un enroulement de fil (14), la région des entrelacs de la connexion supraconductrice, cela avant d'exécuter le dépôt chimique à partir d'une phase gazeuse et en laissant subsister des espaces intermédiaires entre les fils individuels de la tresse de fils ou entre les spires de l'enroulement de fil (14).

6. Procédé selon l'une des revendications 1 à 5, caractérisé par le fait que la région de la connexion est électriquement shuntée au moyen d'un matériau à grande conductibilité, de préférence au moyen d'une enveloppe fermée (18) faite de cuivre, dont la section droite est dimensionnée en fonction des impératifs de refroidissement et de capacité de transport de courant.

Fig.1

Fig. 2